# EUROPEAN PATENT SPECIFICATION

(11) **EP 0 866 736 B1**
(45) Date of publication and mention of the grant of the patent: **08.09.1999**
(21) Application number: 96940952.3
(22) Date of filing: 11.12.1996
(51) Int. Cl.: B05D 7/14, C09D 177/00, C09D 177/06, C08G 69/26, C08G 69/08

(54) **COATING OF UN-PRIMED METALS WITH POLYAMIDE POWDER COATING COMPOSITIONS**
VERFAHREN ZUM BESCHICHTEN VON NICHTGRUNDIERTEM METAL MIT POLYAMIDPULVERZUSAMMENSETZUNGEN
REVETEMENT POUR METAUX N'AYANT PAS SUBI DE TRAITEMENT PREALABLE, AVEC DES COMPOSITIONS CONSTITUEES DE POUDRE DE POLYAMIDE

(30) Priority: 11.12.1995 US 8479 P; 05.12.1996 US 761107
(43) Date of publication of application: 30.09.1998
(73) Proprietor: DUPONT CANADA INC., Mississauga, Ontario L5M 2H3 (CA)
(72) Inventor: NG, Howard, Chung-Ho, Kingston, Ontario K7O 2B4 (CA)
(74) Representative: Jones, Alan John
(86) International application number: CA9600824
(87) International publication number: WO9721496

(56) References cited:
- EP-A- 0 306 165
- BE-A- 679 902
- KUNSTSTOF EN RUBBER, vol. 47, no. 1, 1 January 1995, pages 30-32, XP000500548 G. PECK: "WERVELSINTEREN MET POLYAMIDEPOEDER"

## Description

### FIELD OF THE INVENTION

The present invention relates to a method of coating un-primed metals with polyamide powder coating compositions, and especially to such a method where the polyamide powder coating composition is applied to aluminum or steel that has not been primed. In addition, the present invention relates to a method of coating un-primed metals with polyamide powder coating compositions at lower temperatures, e.g. by 20°C or more, which for electrostatic spray methods may be at a temperature of less than 200°C.

### BACKGROUND TO THE INVENTION

Powder coating compositions are well known and are used in a wide variety of end uses. Many polymers used in powder coating compositions are generally classified as acrylic polymers and are particularly used in the paint industry e.g., in the application of paints or undercoats for paints in the automotive industry. Other metal objects are also coated with such powder coatings. In addition, powder coatings based on polymers generally classed as polyolefins e.g. polyethylene, are also used in the coating of metals e.g., steel, for a variety of uses e.g. pipelines and other metal objects. Such polyolefins are modified polyolefins e.g., polyolefins that have been grafted with a polar monomer in order that an acceptable level of adhesion may be achieved.

Powder coating compositions formed from polyamides are also known. Examples of polyamide powder coating compositions are compositions formed from functionalized nylon 11 or nylon 12 polymers, examples of which include the compositions of polyamide and polycondensate of an aromatic sulfonamide and aldehyde or dicarboxylic acid disclosed in U.S. 5,387,653. It is understood that these functionalized polyamides may be applied to metal substrates, including aluminum and steel, without use of a primer. However, it is also understood that such functionalized polyamides need to be applied at temperatures of at least about 220°C, in the case of electrostatic spray coating and about 300°C in fluidized bed coating. Furthermore, in coating such polyamides to un-primed metal surface, very elaborated metal surface pretreatments may be required, including degreasing with solvents or alkalis, followed by mechanical blasting or chemical treatment for steel or ferrous alloys, degreasing and mechanical blasting for aluminum, and zinc phosphating or chromating for galvanized products.

It is well known to those skilled in the art of polyamide powder coating that the coating thickness limit on metals such as aluminum in a single dip fluidized bed application is about 1.0 mm at temperatures in the range of 300-350°C. Coatings thicknesses greater than 1.0 mm can be obtained by dipping in several stages. In electrostatic spray coating processes, the thickness limit in a single application of polyamide powder is about 0.40 mm, with the likelihood that the powder will fall off during fusion if the coating is thicker than about 0.40 mm.

PCT Patent Application WO92/12194 of N. Farkas et al., published July 23, 1992, discloses polyamides consisting essentially of between about 0 and about 99.5 mole percent of at least one aliphatic diamine having 4-12 carbon atoms and a complementary amount of 2-methyl-pentamethylene diamine polymerized with at least one aliphatic dicarboxylic acid having 6-12 carbon atoms, with the polyamide having an RV greater than about 20. While the published patent application is primarily directed to injection moulding of compositions containing fillers, it is stated that articles may be formed from the polyamide compositions that do not contain filler. Examples of the latter include powder coatings. The use of a polyamide formed from adipic acid and mixtures of hexamethylene diamine/2-pentamethylene diamine (65/35) in a powder coating process using aluminum is exemplified therein. Such polymer has a melting point of about 240°C. In that example, the fluidized bed powder coating was done at a substrate preheat temperature of 315°C, and 1.6 mm thick layer of polyamide was coated onto the aluminum plaque.

Such a thick coating by a single dip would seem to be anomalous, when compared with results of polyamide coatings on metal substrates obtained by others skilled in the art.

Japanese 02/155960A of Daicel Huls KK, published June 15, 1990 discloses powder coating compositions based on polyhexamethylene dodecamide, optionally with up to 10% by weight of comonomers and preferably with a relative viscosity of 1.5-1.8 in m-cresol, and the coating thereof on degreased and primed metal surfaces by fluidized bed, electrostatic spray and electrostatic-fluidized bed coating processes.

Powder coating compositions that provide acceptable coatings without requiring extensive surface pretreatment of the metal substrates, and which have melting points of less than 180°C, and in particular less than 160°C, would be useful in the powder coating industry, for ease of application.

### SUMMARY OF THE INVENTION

It has now been found that powder coating compositions may be obtained from polyamides having lower temperatures of application, and, moreover, that such polyamide powder coating compositions may be applied to un-primed aluminum and steel.

Accordingly, the present invention provides a method for the coating of a metal surface comprising:
(a) contacting un-primed metal surface selected from aluminum and steel in a powder coating process with a powder formed from a polyamide, at least some adjacent amide linkages along the polymer backbone having at least one pendant alkyl branch of 1-3 carbon atoms and at least some adjacent amide linkages along the polymer backbone having sequences of at least seven consecutive carbon atoms, said polyamide having a relative viscosity in formic acid measured at 25°C using 8.4% polymer of at least 20 and a melting point in the range of 140-200°C; and
(b) forming a fused coating of said polyamide on said metal surface, said coating having a hardness of at least 60 Shore D units. In embodiments, the fused coating has a hardness of at least 70 Shore D hardness units, and most preferably at least 75 Shore D hardness units.
In preferred embodiments of the method of the present invention, the polyamide consists essentially of between about 0 and 99.5 mole percent of at least one aliphatic diamine having 4-12 carbon atoms, especially hexamethylene diamine, and a complementary amount of 2-methyl-pentamethylene diamine, said diamines being polymerized with 1,12-dodecanedioic acid.
In further embodiments, the polyamide is a homopolymer of 2-methyl-pentamethylene diamine and dodecanedioic acid or a copolymer formed from a mixture of hexamethylene diamine with 2-methyl-pentamethylene diamine and 1,12-dodecanedioic acid.
The present invention also provides a method for the coating of a metal surface comprising:
   (a) contacting un-primed metal surface selected from aluminum and steel in a powder coating process with a powder formed from a polyamide, and
   (b) forming a fused coating of said polyamide on said metal surface, the improvement comprising reducing the temperature of step (b) by at least 20°C and using a polyamide having at least some adjacent amide linkages along the polymer backbone having at least one pendant alkyl branch of 1-3 carbon atoms and at least some adjacent amide linkages along the polymer backbone having sequences of at least seven consecutive carbon atoms, said polyamide having a relative viscosity in formic acid measured at 25°C using 8.4% polymer of at least 20 and a melting point in the range of 140-200°C.
In addition, the present invention provides a method for the coating of a metal surface comprising:
   (a) contacting un-primed metal surface selected from aluminum and steel in a powder coating process with a powder formed from a polyamide, and
   (b) forming a fused coating of said polyamide on said metal surface, the improvement comprising improving adhesion to send unprimed metal surface by using a powder coating of a polyamide having at least some adjacent amide linkages along the polymer backbone having at least one pendant alkyl branch of 1-3 carbon atoms and at least some adjacent amide linkages along the polymer backbone having sequences of at least seven consecutive carbon atoms, said polyamide having a relative viscosity in formic acid measured at 25°C using 8.4% polymer of at least 20 and a melting point in the range of 140-200°C.

### DETAILS OF THE INVENTION

The polyamides used to form the fused powder coating on the un-primed metal surface of the present invention have at least some adjacent amide linkages along the polymer backbone having at least one pendant alkyl branch of 1-3 carbon atoms and at least having sequences of at least seven consecutive carbon atoms, and have a melting point of 140-200°C. Examples of such polyamides may be prepared from:
(a) at least one dicarboxylic acid and at least one diamine, wherein the at least one dicarboxylic acid and/or the at least one diamine contain at least one alkyl branch having one to three carbon atoms; and wherein the at least one dicarboxylic acid and/or at least one diamine have a sequence of at least seven methylene groups;
(b) at least one alpha, omega aminocarboxylic acid, having the formula of H₂N-R₁-COOH, in which R₁ is an aliphatic moiety having at least seven methylene groups in sequence and at least one pendant alkyl branch having 1 to 3 carbon atoms;
(c) at least one diamine and at least one nitrile selected from the group consisting of alpha, omega-amino alkylene nitriles and alpha omega alkylene dinitriles, wherein the diamine, nitrile and/or dinitrile contain at least one alkyl branch having one to three carbon atoms; and wherein the diamine, nitrile or dinitrile comprise at least seven methylene groups; or
(d) mixtures of any of the monomers described in (a)-(c) above.

Examples of unbranched diamines include 1,6 hexamethylene diamine; 1,8 octamethylene diamine; 1,10 decamethylene diamine and 1,12-dodecamethylene diamine. Examples of branched diamines include 2-methylpentamethylene diamine, but other branched diamines having C₁-C₃ alkyl branches may be used.

Examples of the unbranched dicarboxylic acids include 1,6-hexanedioic acid (adipic acid); 1,7-heptanedioic acid (pimelic acid); 1,8-octanedoic acid (suberic acid); 1,9-nonenedioic acid (azelaic acid); 1,10-decanedioic acid (sebacic acid) and 1,12-dodecanedioic acid. Examples of branched dicarboxylic acids include 2-methyl glutaric acid, but other branched dicarboxylic acids having C₁-C₃ alkyl branches may be used.

Examples of alpha omega amino carboxylic acids are aminocaproic acid, amino octanoic acid, amino decanoic acid, amino undecanoic acid and aminododecanoic acid. It should be noted that the aminocarboxylic acid may be in the form of a lactam, especially when the aliphatic moiety has six methylene groups. Examples of branched alpha, omega amino carboxylic acids are 2-methyl-amino dodecanoic acid and 2-methyl-amino decanoic acid although other related acids may be used.

Examples of the nitriles are 1,5 aminocapronitrile, adiponitrile, 1,11-amino undecanonitrile, 1,10-amino decanodinitrile and 2-methyl- 1,11-amino undecanonitrile although other related nitriles may be used.

In addition to monomers (a)-(c) listed herein, other monomers may be used to prepare the polyamides of the present invention. These other monomers include, but are not limited to, aromatic dicarboxylic acids, aromatic diamines, alicyclic dicarboxylic acids, and alicyclic diamines. Examples of aromatic dicarboxylic acids include terephthalic and isophthalic acids. An example of an alicyclic dicarboxylic acid is 1,4-bismethylene cyclohexyl dicarboxylic acid. An example of an alicyclic diamine is 1,4-bismethylene diamino cyclohexane.

The polyamides may be manufactured using processes well known in the art. In particular, the polyamides may be polymerized from salts of the diamine and dicarboxylic acid. Alternatively, the polyamides may be polymerized using the corresponding nitriles as discussed above.

The polyamide may be in the form of a homopolymer polymerized from one diamine and one dicarboxylic acid, an aminocarboxylic acid an amino alkyl nitrile, or one diamine and a dinitrile. Alternatively, the polyamide may be a copolymer polymerized from at least one diamine with more than one dicarboxylic acid or at least one dicarboxylic acid with more than one diamine or a combination of at least one diamine, at least one dicarboxylic acid and at least one aminocarboxylic acid, optionally containing nitriles.

The polyamides used in the method of the invention preferably contain at least about 20 mole percent of branched moieties, more preferably at least about 30 mole percent and most preferably at least about 50 mole percent of branched moieties, based on the total amount of the aliphatic moieties in the polyamide. Similarly, the polyamides also contain at least 20 mole percent of moieties having at least seven consecutive methylene groups preferably at least 30 mole percent and especially about 50 mole percent of such moieties.

Preferred examples of such polyamides include homopolymers of 2-methyl pentamethylene diamine with dodecanedioic acid or decanedioic acid. Other preferred polyamides include copolymers of hexamethylene diamine and 2-methyl pentamethylene diamine with dodecanedioic acid or decanedioic acid, in which the ratio of the diamines is in the range 10:90 to 90:10. Other preferred polyamides include copolymers of 2-methyl pentamethylene diamine with dodecanedioic or decanedioic acid, and terephthalic or isophthalic acid, in which the ratio of the aliphatic to aromatic dicarboxylic acids is in the range of 99:1 to 70:30, and copolymers of 1,12-dodecamethylene diamine and 2-methyl pentamethylene diamine with adipic acid, in which the ratio of the diamines is in the range of 10:90 to 90:10.

Depending on the combination of monomers used, the polyamides of the present invention can be semi-crystalline or amorphous. When the polyamide is semi-crystalline, it is desirable that such polyamide exhibit a melting point less than or equal to about 200°C as well as a broad melting profile, which is herein defined as the range of temperature between the melting point and the onset of the melting curve in a differential scanning calorimetry (DSC) test. Thus it is preferred that the polyamide have the characteristic of melting over a broad temperature range rather than a sharp melting point, in order to provide adhesion with acceptable strength to the un-primed metal surfaces.

The polyamides of the present invention may contain additives such as, but not limited to, heat stabilizers, flame retardants, fillers, antiblocking agents, slip additives, anticratering agents, leveling agent, pigments or dyes, processing aids, antioxidants, plasticizers or ultraviolet blocking agents.

Examples of the fillers that may be added to the compositions include talc, calcium and manganese carbonates, potassium and aluminum silicates, calcium or magnesium stearates, and the like.

Examples of the pigments include titanium dioxide, zinc phosphate, carbon black and iron oxides.

Examples of UV or other stabilizers include phenolic antioxidants, aliphatic or alicyclic sterically hindered amines and aromatic mono-, di- or polyamines. Metal deactivators may also be added. Typical amounts of such stabilizers are about 0.01 to about 2.5% by weight, preferably 0.1 to 2.0% by weight.

The compositions may be prepared by a variety of methods including dry blending or melt compounding of the additives and the polyamide. In the case of melt compounding, a single screw extruder equipped under suitable mixing screws may be used, but it is more preferable to utilize a twin screw extruder.

In the present invention, the relative viscosity (RV), measured at 25°C for 8.4 wt% of polymer in 90% formic acid, of the polyamides is greater than about 20, preferably ranging from 30 to 60, and more preferably from 35 to 50.

In the present invention, the powders suitable for primerless coating on metal surface may be ground from the solid polyamide in cryogenically cooled apparatus by methods well known to those skilled in the art of polyamide powder coating, such as using attrition, blade, hammer and disk grinders. The powder particles obtained are selected in an appropriate manner by methods such as, but not limited to, sieve screening and turbine air classification, to eliminate the particle size fractions that are undesirable for the metal coating, for example, excessively coarse or fine particles.

In the present invention, the particle size distribution of the powders ground from the said polyamide should range from 5 micro meter to 1 millimetre.

In the present invention, the metal substrate which can be coated, without use of a primer, by the polyamide powder may be selected from a wide range of materials, including, but not limited to ordinary or galvanized steel, aluminum or aluminum alloy. A wide variety of shapes and thicknesses of the metal substrate may be used.

Acceptable levels of adhesion of the coating to the metal substrate, without the use of primer, may be achieved by coating the polyamide onto a clean metal surface without special metal surface treatment. Similar levels of adhesion may also be achieved on metal substrates that have been surface treated by cleaning techniques well known to those skilled in the art, including, but not limited to, degreasing, sand blasting, scouring, iron and zinc phosphating, chromating and anodizing, rinsing, passivation, oven drying and a combination of these treatments.

In the present invention, the application of the powder ground from the polyamide to the metal substrate may be carried out by conventional powder coating techniques. Representative of these techniques are fluidized bed dip-coating, electrostatic spraying, flocking and flame spraying.

In a fluidized bed dip-coating method, the un-primed metal part to be coated is heated in an oven to a temperature determined by its nature, shape and the coating thickness required. It is then dipped into the polyamide powder kept in suspension by air (fluidization) in a tank with a porous base. The powder melts in contact with the hot metal surface and forms a layer of coating, the thickness of which is a function of the temperature of the part and the period of dipping in the powder. The particle size distribution of the said powder used in the fluidized bed dip-coating normally ranges from 10 to 1000 micro meter, and is preferably from 80 to 200 micrometer. The thickness of the coating normally ranges from 150 to 1,000 micrometer, preferably from 200 to 700 micrometer.

The powder ground from the polyamide may also be coated on the un-primed metal substrate by the electrostatic spray method. In this method, the powder is fed via a gun into a nozzle at a high electrical potential, generally from about 10 to over 100 kV. The applied voltage may be of positive or negative polarity. The flow rate of the powder in the gun may range from 10 to 200g/min., and preferably from 50 to 120g/min. On passing through the nozzle the powder becomes charged. The charged particles are sprayed onto the un-primed metal surface to be coated, which is grounded, i.e., at zero voltage. The powder particle is held on the surface by the electrostatic charge, such that the powdered object can be removed and heated in an oven at a temperature which causes the powder to melt, so producing a continuous coating on the metal surface. In the present invention, this coating temperature may be advantageously below 200°C, at least about 10°C (preferably at least) lower than the temperature required according to general teachings of the art. The particle size distribution of the said powder used in the electrostatic spray coating may range from 5 to 100 micrometers, and preferably from 5 to 65 micrometers. The thickness of the coating may range from 40 to 400 micrometers.

In the present invention, the powder of the polyamide may also be coated onto un-primed metal substrates by the flocking method, in which the metal object is pre-heated in an oven and then coated by the electrostatic spraying technique. The coating conditions and powder size requirements are similar to that used in electrostatic spraying method. The coating temperature (pre-heating temperature) may also be advantageously below 200°C.

As exemplified below, the coating of the polyamide on the unprimed steel or aluminum surface has adhesion to the metal surface better than or equal to the adhesion of the functionalized self-adhering nylon coating which contains adhesion promotion agents, as taught by U.S. Patent No. 5.387,653.

Moreover, the coating of the polyamide on the unprimed steel or aluminum surface has adhesion to the said metal surface better than or equal to the adhesion of a conventional polyamide powder coated to the same metal surface with or without the use of primer.

The coating of the polyamide on the unprimed steel or aluminum substrates according to the present invention has an advantageously high resistance to indentation and scratch. Indentation resistance is indicated by Shore D hardness. Scratch resistance is indicated by Konig hardness. The coating has a indentation hardness at ambient conditions of at least 60 Shore D units, more preferably at least 70 Shore D units and most preferably 75 Shore D hardness units. The coating also has a scratch hardness at ambient conditions of at least 60 Konig hardness units, more preferably 80 Konig hardness units and most preferably about 105 Konig hardness units.

As exemplified herein, the coating of the polyamide on the unprimed steel or aluminum substrates obtained according to the method of the present invention has an advantageously high resistance to indentation and scratch at temperatures above its glass transition temperature and up to about 20°C below its melting point. This advantageous property, indicated by the temperature dependence of both Shore D and Konig hardness, makes the polyamide suitable for coating applications under higher temperature conditions.

The polyamide used in the method of the present invention exhibits low melt viscosity at low shear rate, in the applicable temperature range of powder coating, in comparison to the melt of Nylon 11. The melt rheology of the polyamide also exhibits a near Newtonian flow behavior at shear rates below 300 sec⁻¹. These melt properties of the polyamide are advantageous in powder coating in that the lower melt viscosity of the melt may result in better leveling during forming of the coating, which gives smoother coating surface. The Newtonian flow property may advantageously contribute to easier processing control during powder coating.

The coating of the polyamide on the un-primed steel or aluminum substrates according to the present invention has advantageously high barrier properties towards gaseous or vapor transmission. The coating will exhibit an oxygen permeation rate of less than about 60 cc-mil/100 in²/day as determined according to ASTM-398581. The coating will also exhibit a water vapor transmission rate of less than 30 g.mil/100 in2/day, as determined according to ASTM F-1249-90. These gas barrier properties of said coating provide good chemical resistance of the metal articles coated with the polyamide.

The end use applications of the present invention include, but are not limited to, functional (for example, protective) and decorative metal coatings which require indentation and scratch hardness, abrasion resistance, mar resistance, impact strength, corrosion resistance, weatherability, chemical resistance, W stability, colour, adhesion and toughness. Examples include refrigerator and dishwasher racks, outdoor metal furniture, industrial pump housings, industrial instrument housings, sport protective wire masks, fan screens, engine flywheels and the like.

Test methods used herein were as follows:
The adhesion of the coating to metal substrate adhesion was determined according to the procedures of U.S. Patent 5,387,653, briefly summarized as follows:
Using a sharp cutting tool, two parallel incisions, 10 mm apart, were made, both penetrating the coating and exposing the metal. Another incision was then cut at right angles to the first two incisions. Using a blade with a width of 10 mm, the last groove was penetrated to the metal/coating interface, to produce a tongue in the coating. This tongue was then pulled, to try to separate the coating from the metal. The results, referred to as "adhesion rating", are classified as follows:
Class 0: Coating not bonded to the surface at all.
Class 1: Coating separates easily from the surface, i.e., the bond is weak.
Class 2: Coating separates evenly, the force required for tearing off the coating is at or about the tensile strength of the coating.
Class 3: Coating separates irregularly, over less than 50% of the surface area.
Class 4: Coating cannot be separated from the metal.

Shore D Hardness is a measure of the indentation resistance of the polymer coating, and is determined according to ASTM D-2240-91.

Konig Hardness is a measure of the scratch resistance of the polymer coating, and is determined according to ASTM D-4366.

Melt rheology of the polyamide in the powder coating was determined using a Kayeness melt rheometer, according to the test procedure of ASTM D-3835.

Melting point and glass transition temperature were determined using the procedure of ASTM D-3418 (1988) using a DuPont DSC Instrument Model 2100; the heating and cooling rates were 10°C/min. Relative viscosity was measured using procedures described in Jennings, U.S. 4 702 875.

The present invention is illustrated by the following examples.

A homopolyamide of 2-methyl pentamethylene diamine (D) and dodecanedioic acid, referred to as D12, was prepared from a typical autoclave polycondesation process according to known procedures e.g. as described in aforementioned PCT WO92/12194, Example XV. The homopolyamide obtained had a relative viscosity (RV) of 40. The melting point and the glass transition temperature of D12 are given in Table I, together with data obtained on Nylon 11.

**Table 1**

| **Melting Point and Glass Transition Temperature**^{**2**} **D12 vs Nylon 11** | | |
|---|---|---|
| **Polymer** | **Melting Point (°C)** | **Glass Transition Temperature (°C)** |
| D12 | 146,160 | 49.5 |
| Nylon 11 | 184 | 43 |

The lower melting point of D12 may be advantageous in powder coating to provide lower coating and processing temperatures. In contrast, the glass transition temperature of D12 is higher than that of Nylon 11 by about 6°C, to provide equal or superior temperature-in-use properties (e.g., hardness).

The D12 polymer obtained above was pulverized cryogenically in an attrition mill (Wedco) and screened through a series of screens with given sizes of mesh to eliminate coarse and fine particles. Cryogenic grinding of D12 was found to be efficient and trouble free. The sieve screening process may be replaced by a powder classification process according to size using an air-turbine (e.g. Nisshin) to obtain the required size fractions for powder coating. Screening and classification of D12 powders were-found advantageously efficient and trouble fee.

Typical particle sizes of the D12 powder used in the powder coating tests reported herein are given in Table 2. Mean particle size of the powder was determined by laser diffraction analysis using a Coulter analyzer. The particle size distribution of the D12 powder was adjusted according to the powder coating methods used.

**Table 2**

| **Particle Size of D12 Powder** | |
|---|---|
| **Coating Method** | **Mean Particle Size (Micron)** |
| Fluidized Bed Dip Coating | 110 |
| Electrostatic Spray | 38 |
| Flocking | 38 |

### Example II

This example illustrates the powder coating of un-primed steel with D12 powder by electrostatic spray (ES) techniques.

The procedure was typical of ES coating processes for polyamides, except that the coating and processing temperature was advantageously reduced by 20°C or more. Results obtained are given in Table 3. As a comparison, data is also reported for ES powder coating of un-primed cold roll steel by self-adhering functionalized Nylon 11 containing adhesion promotion agents, reported in U.S. Patent No. 5,387,653.

**Table 3**

| **Powder Coating of Un-Primed Steel D12 vs Nylon 11 Electrostatic Spray Coating**^{**a**} | | | | | |
|---|---|---|---|---|---|
| **Polymer** | **Postheating Oven Temp °C** | **Primer** | **Adhesion** | **Coating Thickness (micron)** | **Remarks** |
| D12 | 192 | No | 4 | 88 | -70 kV voltage |
| | | | | | 3 minutes postheat |
| D12 | 195 | No | 4 | 46 | -50 kV voltage |
| | | | | | 3 minutes postheat |
| D12 | 195 | No | 4 | 132 | -50 kV voltage |
| | | | | | 4 minutes postheat |
| Nylon^{b} | 220 | No | 2-3 | 100 | -30 kV voltage |
| | | | | | 4-15 minutes postheat |

| | | | | | |
|---|---|---|---|---|---|
| ^{a} D12 coating on unpolished cold roll steel panel (ACI Lab, 10.2 ∼c 10.2 ∼c 0.08 cm) | | | | | |
| ^{b} Contains adhesion-promoting agent. The steel plate was treated by zinc phosphating. | | | | | |

It is clearly demonstrated that the adhesion of the coating to metal substrate for D12-unprimed steel is superior than that of functionalized Nylon 11-unprimed steel.

It was found that for pigmented D12 powders, a higher postheat temperature might be required, depending on the choice of pigments and loading. It was also found that dry-blending of pigments with the D12 powder was efficient and trouble free.

Table 4 lists results of powder coating of unprimed cold roll steel panel with D12 dry-blended with pigments. The adhesion of the coating to the un-primed steel surface was excellent in all cases, including when carbon-black pigmented D12 powder was double coated on the panel.

**Table 4**

| **Powder Coating of Un-Primed Steel D12 vs Nylon 11 Electrostatic Spray Coating**^{**a**} | | | | | |
|---|---|---|---|---|---|
| **Polymer** | **Postheating Oven Temp °C** | **Primer** | **Adhesion** | **Coating Thickness (micron)** | **Remarks** |
| D12 + 7% TiO₂ | 200 | No | 4 | 147 | -60 kV |
| | | | | | 3 minutes postheating |
| D12 + 2% Carbon Black Doubly Coated | 215 | No | 4 | 94 | -50 kV |
| | | | | | 3 minutes postheating |
| D12 + 2% | 215 | No | 4 | 200 | -50 kV |
| | | | | | 4 minutes postheating |
| D12 + 2.8% Blue Pigment | 252 | No | 3-4 | 192 | -60 kV |
| | | | | | 5 minutes postheating |

| | | | | | |
|---|---|---|---|---|---|
| ^{a} Coating on unpolished cold roll steel panel (ACT Lab, 10.2 x 0.08 cm) | | | | | |
| ^{b} The pigment in each formulation was dry-blended with the D12 powder. TiO₂ was of DuPont TiPure grade. Carbon black was from Abbot. The Blue Pigment was Sun Forest Blue from Sun Chemicals. | | | | | |

Electrostatic spray coating of D12 was found to be advantageously possible under positive or negative applied voltage. It was also found that the coating film thickness could be controlled by adjusting the applied voltage of the spray gun.

The appearance of the D12 coating on un-primed steel substrates is generally rated superior by persons skilled in the art of powder coating. The coating surface is smooth and free of defects, provided that the substrate is blemish free.

### Example III

This example illustrates powder coating of unprimed steel with D12 powder by fluidized bed dip coating (FB) techniques.

The procedure was typical of FB coating techniques except that a reduction in coating and processing temperature of about 20°C or more was possible.

Table 5 lists the results of FB powder coating of un-primed cold roll steel panel with D12, compared with the coating results with Nylon 11.

**Table 5**

| **Powder Coating of Un-Primed Steel D12 vs Nylon 11 Fluidized Bed Dip Coating**^{**a**} | | | | | |
|---|---|---|---|---|---|
| **Polymer** | **Postheating Oven Temp °C** | **Primer** | **Adhesion** | **Coating Thickness (micron)** | **Remarks** |
| D12 | 304 | No | 4 | 558 | 5 min. preheat, 3 sec. dip, |
| | | | | | 1 min. postheat at 255°C |
| Nylon 11^{b} | 354 | No | 1 | 233 | 6 min. preheat 2 sec. dip, |
| | | | | | 1 min. postheat at 280°C |

| | | | | | |
|---|---|---|---|---|---|
| ^{a} The steel metal substrate is unpolish cold roll steel panel, 10.2 x 15.2 x 0.08 cm (4x6 1/32 inch) (supplied by ACT Laboratories, Inc., Hillsdale, MI). | | | | | |
| ^{b} The Nylon 11 powder is a grey pigmented commercial Fluidized-Bed grade (Rilsan). Average particle size is 124 micron. | | | | | |

Excellent adhesion of the D12-unprimed steel was observed (Adhesion rating:4). In direct comparison, it is evident that the adhesion of Nylon 11 - unprimed steel is poor (Adhesion rating:1) and is much inferior to the D12 coating.

Results in Table 5 also indicate that under similar FB coating conditions, D12 has an advantage of easier coated film-built-up (higher coating thickness) than Nylon 11. This effect will contribute to easier machinability i.e. mechanical polishing of the coated parts, a common practice used in the coating industry. It is conceivable that the lower melting temperature of D12 enables easier heat transfer for the forming of the D12 melt layer during coating, leading to thicker coating thickness.

Table 6 lists the results of FB powder coating of un-primed but sand blasted steel substrate with D12. in comparison with Nylon 11. Excellent coating/metal adhesion is evident in D12/un-primed-sand blasted steel (Adhesion:4), whereas the adhesion of Nylon 11/un-primed - sandblasted steel is poor (Adhesion:1-2).

**Table 6**

| **Powder Coating of Un-Primed but Sand Blasted Steel D12 vs Nylon 11 Fluidized Bed Dip Coating**^{**a**} | | | | | |
|---|---|---|---|---|---|
| **Polymer** | **Postheating Oven Temp °C** | **Primer** | **Adhesion** | **Coating Thickness (micron)** | **Remarks** |
| D12 | 275 | No | 4 | 483 | 30 minutes preheat, |
| | | | | | 8 sec. dip. air cool |
| D12 | 325 | No | 4 | 930 | 30 minutes preheat, |
| | | | | | 8 sec. dip. air cool |
| D12^{b} | 325 | No | 4 | 543 | 30 minutes preheat, |
| | | | | | 8 sec. dip. water quenched |
| N11^{c} | 325 | No | 1-2 | 341 | 30 minutes preheat, |
| | | | | | 8 sec. dip. air cool |
| N11^{c} | 325 | No | 1 | 355 | 30 minutes preheat, |
| | | | | | 8 sec. dip. air cool |

| | | | | | |
|---|---|---|---|---|---|
| ^{a} Coating on thick cold roll steel panel (7.62 x 15.24 x 0.32 cm) (3 x 6 x 1/8 in), sand blasted (from ACT Lab.) | | | | | |
| ^{b} Water quenching gave excellent glossy appearance of the coating. | | | | | |
| ^{c} Commercial Fluid-Bed grade Nylon 11 natural powder (Atochem, Natural RDP 15-10 FB). | | | | | |

Table 7 lists the results of FB powder coating of un-primed but sand blasted steel, with D12 dry-blended with pigment, in comparison to Nylon 11 blended with pigment. Superior adhesion is evident from D12 with pigment coated on sand blasted un-primed steel substrate (Adhesion:3-4). The adhesion of Nylon 11 with pigment on the same surface is poor (Adhesion:1).

**Table 7**

| **Powder Coating of Un-Primed but Sand Blasted Steel D12 vs Nylon 11-Effect of Pigments Fluidized Bed Dip Coating**^{**a**} | | | | | |
|---|---|---|---|---|---|
| **Polymer** | **Postheating Oven Temp °C** | **Primer** | **Adhesion** | **Coating Thickness (micron)** | **Remarks** |
| D12^{b} + 7% TiO₂ | 300 | No | 3-4 | 508 | 8 minutes preheat, |
| | | | | | 2 sec. dip, Air cool |
| Nylon 11^{c} grey pigment | 354 | No | 1 | 412 | 8 minutes preheat, |
| | | | | | 2 sec. dip, Air cool |

| | | | | | |
|---|---|---|---|---|---|
| ^{a} Coating on thick cold roll steel panel (3 x 6 1/8 in) sand blasted (from ACT Lab). | | | | | |
| ^{b} TiO₂ of DuPont Ti-pure grade. | | | | | |
| ^{c} Rilsan commercial Fluid-Bed grade. | | | | | |

Table 8 lists the results of FB powder coating of industrial steel parts, comparing D12 coated on unprimed steel object to Nylon 11 coated on the same object which had been pretreated on the surface by a commercial primer using a conventional priming process. The adhesion of D12/un-primed steel part is excellent (adhesion:4), whereas the adhesion of Nylon 11/primed steel part is acceptable but inferior to D12 (Adhesion 3-3.5).

**Table 8**

| **Powder Coating of Industrial Steel Part D12-Primerless vs Nylon 11-Primed Fluidized Bed Dip Coating**^{**a**} | | | | | |
|---|---|---|---|---|---|
| **Polymer** | **Substrate Temp. °C** | **Primer** | **Adhesion** | **Coating Thickness (micron)** | **Remarks** |
| D12 | 205 | No | 4 | 880 | Preheat for 30 minutes |
| | | | | | 14 seconds dip time |
| Nylon^{b} | 205 | Yes | 3-35 | 432 | Preheat for 30 minutes |
| | | | | | 14 seconds dip time |

| | | | | | |
|---|---|---|---|---|---|
| ^{a} 6" OD steel fly wheel (1-inch thick weighting about 1-2 lbs, grit blasted, either unprimed or primed), used as a harmonic dampener in the engine of a racing car. | | | | | |
| ^{b} Commercial Fluid-Bed grade Nylon 11 powder containing 20-30% carbon black. | | | | | |

Table 9 lists the results of FB powder coating of un-primed commercial steel parts. The adhesion of D12 coating on an industrial battery handle (un-primed steel surface) is excellent (Adhesion:4), whereas the adhesion of a functionalized Nylon 11 (Nylon 11 containing adhesion promotion agent) coated on an industrial gutter hook (un-primed steel surface) is acceptable but inferior to D12 (Adhesion 3-3.5).

**Table 9**

| **Powder Coating of Un-Primed Commercial Steel Parts D12 vs Nylon 11 Fluidized Bed Dip Coating** | | | | |
|---|---|---|---|---|
| **Polymer** | **Primer** | **Adhesion** | **Coating Thickness (micron)** | **Remarks** |
| D12^{a} | No | 4 | 635 | Pigmented with 2.3% Ferro Green |
| Nylon 11^{b} + Adhesion Promotion Agent | No | 3-3.5 | ∼500 | Pigmented with Carbon Black |

| | | | | |
|---|---|---|---|---|
| ^{a}Coating condition-6 minutes preheating at 337°C, 2 second dip, postheat at 302°C for 1 minute. | | | | |
| ^{b} Commercially available. | | | | |

The appearance of the FB contained D12 coating on un-primed steel substrates is generally rated superior by persons skilled in the art of powder coating. The coating surface is smooth and free of defects, provided that the substrate is blemish free.

### Example IV

This example illustrates powder coating of un-primed aluminum with D12 powder by fluidized bed dip coating (FB) techniques.

The procedure was typical FB coating techniques except that a reduction in coating and processing temperature of about 20°C or more was possible.

Table 10 lists the results of FB powder coating of un-primed aluminum panel with D12, versus Nylon 11.

In both cases no primer used. The adhesion was superior for D12 (adhesion:2-3) than for nylon 11 (adhesion:1).

**Table 10**

| **Powder Coating of Un-Primed Aluminum D12 vs Nylon 11 Fluidized Bed Dip Coating**^{**a**} | | | | | |
|---|---|---|---|---|---|
| **Polymer** | **Postheating Oven Temp °C** | **Primer** | **Adhesion** | **Coating Thickness (micron)** | **Remarks** |
| D12 | 315 | No | 2-3 | 605 | 8 minutes preheat, |
| | | | | | 2 sec. dip, Air cool |
| Nylon 11^{b} | 354 | No | 1 | 330 | 8 minutes preheat, |
| | | | | | 2 sec. dip, Air cool |

| | | | | | |
|---|---|---|---|---|---|
| ^{a} Coating on thick, Aluminum panel, unpolished (7.6 x 10.2 x 0.32 cm - 3 x 4 x 1/8 inch). | | | | | |
| ^{b} Rilsan commercial Fluid-Bed grade, grey pigmented. | | | | | |

Table 11 gives results of FB powder coating of an un-primed but sand blasted aluminum industrial article using D12. Excellent adhesion between the D12 coating and the aluminum substrate was observed (Adhesion:4).

**Table 11**

| **Powder Coating of Un-Primed but Sand Blasted Aluminum Industrial Article**^{**a**} **Using D12 Fluidized Bed Dip Coating** | | | | | |
|---|---|---|---|---|---|
| **Polymer** | **Postheating Oven Temp °C** | **Primer** | **Adhesion** | **Coating Thickness (micron)** | **Remarks** |
| D12 | 260 | No | 4 | 375 | 10 minutes preheat, |
| | | | | | 4 second dip |
| Nylon 11^{c} grey pigment | 354 | No | 1 | 412 | 8 minutes preheat, |
| | | | | | 2 sec. dip, Air cool |

| | | | | | |
|---|---|---|---|---|---|
| ^{a} Aluminum Support bracket-1/8" thickness and one foot length. | | | | | |

Appearance of the FB coated D12 coating on unprimed aluminum substrate is generally rated superior by persons skilled in the art of powder coating. The coating surface is smooth and free of defects, provided that the substrate is blemish free.

### Example V

This example illustrates powder coating of un-primed steel with D12 powder by flocking techniques.

The procedure was typical of flocking techniques except that a reduction in coating and processing temperature of about 20°C or more was possible.

Table 12 lists the resuits of flocking powder coating of an un-primed but sand blasted steel industrial article, using D12 powder. Excellent adhesion between the D12 coating and the metal substrate was observed (Adhesion:3-4).

**Table 12**

| **Powder Coating ofUn-Primed but Sand Blasted Steel Industrial Article Using D12 Flocking (Fusabond Coating)**^{**a**} | | | | | |
|---|---|---|---|---|---|
| **Polymer** | **Postheating Oven Temp °C** | **Primer** | **Adhesion** | **Coating Thickness (micron)** | **Remarks** |
| D12 | 302 | No | 3-4 | 494 | both positive and negative potential can be applied |

| | | | | | |
|---|---|---|---|---|---|
| ^{a} Industrial fitting connector made of steel, sand blasted, about 1 lb in weight 90 degree curvature, 2 inch ID and 1/4 inch thickness. | | | | | |

### Example VI

Shore D and Konig hardness were determined for both D12 and Nylon 11, at room temperature. The results are reported in Table 13.

The temperature dependence of the Shore D hardness of both D12 and that of Nylon 11, was determined for the usual in-use temperature range of the coated articles (23-7S°C). The results are given in Table 14.

The temperature dependence of the Konig hardness of both D12 and that of Nylon 11 was determined from room temperature to a high temperature of 130°C.

The results are given in Table 15.

**Table 13**

| **Polymer Hardness at 23°C D12 vs Nylon 11** | | |
|---|---|---|
| Polymer | Shore D^{a} Hardness | Konig^{b} Hardness |
| D12 | 75 | 109 |
| Nylon 11 | 75 | 110 |

| | | |
|---|---|---|
| ^{a} Shore D Hardness value is an average of 49 measurements, with standard deviation (Sigma) of 0.7. | | |
| ^{b} Konig Hardness value is an average of 12-15 measurements, with standard deviation (Sigma) of 1.5. | | |

**Table 14**

| **Temperature Dependence of Polyamide Resistance to Indentation: Shore D Hardness. D12 VS Nylon 11** | | | |
|---|---|---|---|
| **Polymer** | **Temperature** | | |
| | **23°C** | **50°C** | **75°C** |
| D12 | 75 | 67 | 61 |
| Nylon 11^{a} | 75 | 66 | 60 |

| | | | |
|---|---|---|---|
| ^{a} Commercially available Rilsan powder from Atochem. | | | |

**Table 15**

| **Temperature Dependence of Polyamide Resistance to Scratch : Konig Hardness, D12 vs Nylon 11** | | | | | |
|---|---|---|---|---|---|
| **Polymer** | **Temperature** | | | | |
| | **23°C** | **50°C** | **75°C** | **100°C** | **130°C** |
| D12 | 109 | 39 | 32 | 38 | 33 |
| Nylon 11^{a} | 110 | 37 | 33 | 34 | 37 |

| | | | | | |
|---|---|---|---|---|---|
| ^{a} Commercially available Rilsan powder from Atochem. | | | | | |

The hardness results indicate that D12 has adequate indentation resistance and scratch resistance properties for metal coating applications, at ambient and high daily use temperatures. The hardness properties of D12 are shown-to be equal to that of Nylon 11 even though D12 exhibits a lower melting point.

### Example VII

The melt rheology properties of both D12 and Nylon 11, at two representative powder coating temperatures (220°C and 250°C), are given in Table 16.

**Table 16**

| **Melt Rheology of D12 vs. Nylon 11** | | | |
|---|---|---|---|
| **Temperature** | **Shear Rate Sec**^{**a**} | **Viscosity Pa-Sec** | |
| | | **D12** | **Nylon 11**^{**b**} |
| 220°C | 10.5 | 405.2 | 496.6 |
| | 100.5 | 354.1 | 389.3 |
| | 301.6 | 308.2 | 318.6 |
| | 603.2 | 248.5 | 238.8 |
| | 1005.3 | 202.3 | 176.4 |
| 250°C | 10.5 | 153.2 | 511.4 |
| | 100.5 | 150.2 | 341.8 |
| | 301.6 | 143.2 | 277.1 |
| | 603.2 | 124.0 | 205.7 |
| | 1005.3 | 108.4 | 143.1 |

| | | | |
|---|---|---|---|
| ^{a} Measured according to ASTM D 3835-90. | | | |
| ^{b} Commercial FB grade Nylon 11 powder (Rilsan), grey pigmented. | | | |

It is noted that D12 exhibits low melt viscosity at low shear rate, in comparison to Nylon 11. The melt viscosity of D12 also indicates near Newtonian flow behavior at shear rates below 300 sec⁻¹. These melt properties of D12 are advantageous in powder coating in that the less viscous D12 melt may result in better leveling of the coating, and consequently gives a smoother coating surface. The Newtonian flow may contribute to easier processing control.

### Example VIII

Water vapor transmission rate ad the oxygen permeability are two properties which reflect the barrier properties of the polymer coating. These properties were measured for both D12 and Nylon 11, and the results are given in Table 17.

**Table 17**

| **Barrier Properties of D12 vs. Nylon 11** | | |
|---|---|---|
| **Barrier** | **D12** | **Nylon 11** |
| Water | 5.9 | 3.4 |
| Vapor Transmission^{a} | | |
| Rate (g.mil/100 in²/day) | | |
| Oxygen | 15.1 | 36.3 |
| Permeability^{b} (Dry) | | |
| (mil.cc/100 in²/day) | | |

| | | |
|---|---|---|
| ^{a} Measured according to ASTM F-1249-90. | | |
| ^{b} Measured according to ASTM D-3985-81 | | |

Generally, commercially available grades of polyolefins have oxygen transmission rates in the range of 100-500 cc-mil/100 in2/day. Other polyamides such as nylon 66 and nylon 6 typically have water vapor transmission rate in the range of 50 g.mil/1002/day. The oxygen permeability and water barrier results of D12 indicate that the D12 coatings have adequate barrier properties in comparison to that of Nylon 11.

### Example IX

A copolyamide of 2-methyl pentamethylene diamine (25 mole%), 1,6-hexamethylene diamine (25 mole%) and dodecenedioic acid (50 mole%), referred to as D12/612, was prepared from a typical autoclave polycondensation process according to the known procedures referred to Example I of this invention. The copolyamide obtained had a relative viscosity (RV) of 32. The melting point, the glass transition temperature and the Shore D hardness (at room temperature) of this copolyamide are: 174 C, 46.8 C and 76, respectively.

The D12/612 copolymer obtained above was pulverized cryogenically in an attrition mill and screened following the procedures described in Example I of this invention.

Powder coating of un-primed steel with D12/612 powder by fluidized bed dip coating (FB) technique is illustrated in this example. The procedure was typical of FB coating techniques except that a reduction in coating and processing temperature of about 10°C or more was possible.

Table 18 lists the results of FB powder coating of un-primed cold roll steel panel with D12/612, compared with the coating results with Nylon 11

**Table 18**

| **Powder Coating of Un-Primed Steel D12/612 vs Nylon 11 Fluidized Bed Dip Coating**^{**a**} | | | | |
|---|---|---|---|---|
| **Polymer** | **Preheating Oven Temp °C** | **Primer** | **Adhesion** | **Remarks** |
| D12/612 | 325 | No | 4 | 2 sec. dip |
| Thin Panel | | | | 1 min. postheat |
| D12/612 | 325 | No | 3.5 | 2 sec. dip |
| Thick Panel | | | | No postheat |
| Nylon 11^{b} | 354 | No | 1 | 2 sec. dip |
| Thin Panel | | | | 1 min. postheat |

| | | | | |
|---|---|---|---|---|
| ^{a} The steel metal substrate is unpolished cold roll steel panel: - Thin panel: 10.2 x 15.2 x 0.08 cm (4 x 6 x 1/32 inch) - Thick panel: 7.7 x 15.2 x 0.32 cm (3 x 6 x 1/8 inch) Supplied by ACT Laboratories Inc., Hillsdale, MI | | | | |
| ^{b} The Nylon 11 powder is a grey pigmented commercial Fluidized-Bed grade (Rilsan). Average particle size is 124 micron. | | | | |

Excellent adhesion of the D12/612-up-primed steel was observed (Adhesion rating: 3.5-4). In direct comparison, it is evident that the adhesion of Nylon 11-un-primed steel is poor (Adhesion rating:1) and is much interior to the D12/612 coating.

## Claims

1. A method for the coating of a metal surface comprising:
(a) contact un-primed steel in a powder coating process with a powder formed from a polyamide which consists essentially of between 0 and 99.5 mole percent of at least one aliphatic diamine having 4-12 carbon atoms, and a complementary amount of 2-methyl-pentamethylene diamine, said diamines being polymerized with 1,12-dodecanedioic acid, said polyamide having a relative viscosity in formic acid measured at 25°C using 8.4% polymer of at least 20 and a melting point in the range of 140-200°C; and
(b) forming a fused coating of said polyamide on said metal surface, said coating having a hardness of at least 70 Shore D units.

2. The method of Claim 1 in which the fused coating has a hardness of at least 75 Shore D hardness units.

3. The method of Claim 1 or Claim 2 in which the aliphatic diamine is hexamethylene diamine.

4. The method of Claim 1 or Claim 2 in which the polyamide is a homopolymer of 2-methyl-pentamethylene diamine and dodecanedioic acid or a copolymer formed from a mixture of hexamethylene diamine with 2-methylpentamethylene diamine and 1,12-dodecanedioic acid.

5. The method of any one of Claims 1-4 in which the polyamide has an RV in the range of 30 to 60.

6. The method of any one of Claims 1-5 in which the powder coating process is a fluidized bed dip-coating process.

7. The method of any one of Claims 1-5 in which the powder coating process is an electrostatic spraying process and the temperature in step (b) is less than 200°C.

8. The method of any one of Claims 1-5 in which the powder coating process is a flocking process.

9. The method of any one of Claims 1-5 in which the powder coating process is a flame spraying process.

## Patentansprüche

1. Verfahren zum Beschichten einer Metalloberfläche, wobei das Verfahren die Schritte umfaßt:
(a) In Kontakt treten lassen eines nicht-grundierten Stahls in einem Pulverbeschichtungsverfahren mit einem aus einem Polyamid gebildeten Pulver, welches im wesentlichen aus zwischen 0 und 99,5 Mol% von wenigstens einem aliphatischen Diamin mit 4 bis 12 Kohlenstoffatomen besteht, und einer komplementären Menge an 2-Methyl-pentamethylen-diamin gebildet ist, wobei die Diamine mit 1,12-Dodecandisäure polymerisiert sind, wobei das Polyamid eine relative Viskosität in Anleisensäure, gemessen bei 25°C unter Verwendung von 8,4% Polymer, von wenigstens 20 sowie einen Schmelzpunkt im Bereich von 140 bis 200°C aufweist, und
(b) Erzeugen einer geschmolzenen Beschichtung des Polyamids auf der Metalloberfläche, wobei die Beschichtung eine Härte von wenigstens 70 Shore-D-Einheiten aufweist.

2. Verfahren nach Anspruch 1, bei dem die geschmolzene Beschichtung eine Härte von wenigstens 75 Shore-D-Einheiten aufweist.

3. Verfahren nach Anspruch 1 oder 2, bei dem das aliphatische Diamin Hexamethylen-diamin ist.

4. Verfahren nach Anspruch 1 oder 2, bei dem das Polyamid ein Homopolymer von 2-Methyl-pentamethylen-diamin und Dodecandisäure oder ein Copolymer ist, das aus einer Mischung von Hexamethylen-diamin mit 2-Methylpentamethylen-diamin und 1,12-Dodecandisäure erzeugt ist.

5. Verfahren nach einem der Ansprüche 1 bis 4, bei dem das Polyamid einen Wert für RV im Bereich von 30 bis 60 zeigt.

6. Verfahren nach einem der Ansprüche 1 bis 5, wobei es sich bei dem Pulverbeschichtungsverfahren um ein Tauchbeschichtungsverfahren in einem Fließbett handelt.

7. Verfahren nach einem der Ansprüche 1 bis 5, wobei es sich bei dem Pulverbeschichtungsverfahren um ein elektrostatisches Sprühverfahren handelt und die Temperatur im Schritt (b) unterhalb von 200°C liegt.

8. Verfahren nach einem der Ansprüche 1 bis 5, wobei es sich bei dem Pulverbeschichtungsverfahren um ein Beflockungsverfahren handelt.

9. Verfahren nach einem der Ansprüche 1 bis 5, wobei es sich bei dem Pulverbeschichtungsverfahren um ein Flammsprühverfahren handelt.

## Revendications

1. Procédé pour le revêtement d'une surface métallique comprenant :
(a) la mise en contact d'acier non apprêté dans un procédé de revêtement en poudre avec une poudre formée à partir d'un polyamide qui est constitué essentiellement de 0 à 99,5% en mole d'au moins une diamine aliphatique présentant 4-12 atomes de carbone et une quantité complémentaire de 2-méthyl-pentaméthylènediamine, lesdites diamines étant polymérisées avec de l'acide 1,12-dodécanedioïque, ledit polyamide présentant une viscosité relative dans de l'acide formique mesurée à 25°C en utilisant 8,4% de polymère d'au moins 20 et un point de fusion dans l'intervalle de 140-200°C, et
(b) la formation d'un revêtement fondu dudit polyamide sur ladite surface métallique, ledit revêtement présentant une dureté d'au moins 70 unités Shore D.

2. Procédé suivant la revendication 1, dans lequel le revêtement fondu présente une dureté d'au moins 75 unités de dureté Shore D.

3. Procédé suivant la revendication 1 ou 2, dans lequel la diamine aliphatique est de l'hexaméthylènediamine.

4. Procédé suivant la revendication 1 ou 2, dans lequel le polyamide est un homopolymère de 2-méthylpentaméthylènediamine et d'acide dodécanedioïque ou un copolymère formé à partir d'un mélange d'hexaméthylènediamine et de 2-méthylpentaméthylènediamine et d'acide 1,12-dodécanedioïque.

5. Procédé suivant l'une quelconque des revendications 1 à 4, dans lequel le polyamide présente une RV (viscosité relative) dans l'intervalle de 30 à 60.

6. Procédé suivant l'une quelconque des revendications 1 à 5, dans lequel le procédé de revêtement en poudre est un procédé par bain en lit fluidisé.

7. Procédé suivant l'une quelconque des revendications 1 à 5, dans lequel le procédé de revêtement en poudre est un procédé de pulvérisation électrostatique et dans lequel la température dans l'étape (b) est inférieure à 200°C.

8. Procédé suivant l'une quelconque des revendications 1-5, dans lequel le procédé de revêtement en poudre est un procédé de flocage.

9. Procédé suivant l'une quelconque des revendications 1-5, dans lequel le procédé de revêtement en poudre est un procédé de pulvérisation à la flamme.
